# FASCICULE DE BREVET EUROPEEN

(11) **EP 2 807 681 B1**
(45) Date de publication et mention de la délivrance du brevet: **22.04.2020**
(21) Numéro de dépôt: 13700927.0
(22) Date de dépôt: 23.01.2013
(51) Int. Cl.: H01L 33/00, H01L 33/18, H01L 33/38, B82Y 10/00, H01L 33/08, H01L 33/24, H01L 33/28, H01L 33/32, H01L 25/16, H01L 27/15, H01L 21/04, B82Y 40/00

(54) **PROCÉDÉ DE RÉALISATION D'UN DISPOSITIF MICROÉLECTRONIQUE COMPRENANT UNE PLURALITÉ DE DIODES ÉLECTROLUMINESCENTES FILAIRES ET JEU CORRESPONDANT D'ENSEMBLES MULTICOUCHES**
VERFAHREN ZUR HERSTELLUNG EINER MIKROELEKTRONISCHEN VORRICHTUNG MIT EINER VIELZAHL VON DRAHTLEUCHTDIODEN UND ENTSPRECHENDE ANZAHL VON MEHRFACHSCHICHTEN
METHOD FOR PRODUCING A MICROELECTRONIC DEVICE COMPRISING A PLURALITY OF WIRE LIGHT-EMITTING DIODES AND CORRESPONDING SET OF MULTILAYER ASSEMBLIES

(30) Priorité: 23.01.2012 FR 1250640
(43) Date de publication de la demande: 03.12.2014
(73) Titulaire: Commissariat à l'Énergie Atomique et aux Énergies Alternatives, 75015 Paris (FR)
(72) Inventeur: LAGRANGE, Alexandre, F-38320 Eybens (FR); LANDIS, Stéphan, F-38500 Voiron (FR)
(74) Mandataire: Hautier, Nicolas
(86) Numéro de dépôt international: PCT/EP2013/051259
(87) Numéro de publication internationale: WO 2013/110671

(56) Documents cités:
- WO-A2-2009/135078
- US-A1- 2010 051 986
- US-B1- 7 906 354
- SHU-CHIA SHIU ET AL: "Transfer of aligned single crystal silicon nanowires to transparent substrates", PROCEEDINGS OF SPIE, vol. 7047, 28 août 2008 (2008-08-28), pages 70470F-1-70470F-8, XP055045512, ISSN: 0277-786X, DOI: 10.1117/12.794384
- HUANG J S ET AL: "Well-aligned single-crystalline silicon nanowire hybrid solar cells on glass", SOLAR ENERGY MATERIALS AND SOLAR CELLS, ELSEVIER SCIENCE PUBLISHERS, AMSTERDAM, NL, vol. 93, no. 5, 1 mai 2009 (2009-05-01), pages 621-624, XP026027448, ISSN: 0927-0248, DOI: 10.1016/J.SOLMAT.2008.12.016 [extrait le 2009-01-25]
- ZHIYONG FAN ET AL: "Wafer-Scale Assembly of Highly Ordered Semiconductor Nanowire Arrays by Contact Printing", NANO LETTERS, vol. 8, no. 1, 1 janvier 2008 (2008-01-01) , pages 20-25, XP055017384, ISSN: 1530-6984, DOI: 10.1021/nl071626r

## Description

### DOMAINE TECHNIQUE DE L'INVENTION

La présente invention concerne les diodes électroluminescentes en général et plus particulièrement celles qui sont produites sous forme d'une multitude de fils de tailles nanométriques ou micrométriques faits de matériaux semi-conducteurs.

### ÉTAT DE LA TECHNIQUE

L'industrie de l'éclairage, qui est encore aujourd'hui largement basée sur la production de lampes à incandescence caractérisées par une grande consommation d'énergie électrique pour un faible rendement lumineux, s'oriente de plus en plus vers la production de dispositifs à base de diodes électroluminescentes qui ont un rendement optique bien meilleur.

En particulier, les nouveaux dispositifs optiques destinés à l'éclairage utilisent des diodes électroluminescentes ou LEDs, acronyme de l'anglais « light emitting diode » c'est-à-dire « diode à émission de lumière ». Un type particulier de LED est basé sur une multitude de fils faits de matériaux semi-conducteurs de tailles nanométriques habituellement appelés « nanofils ».

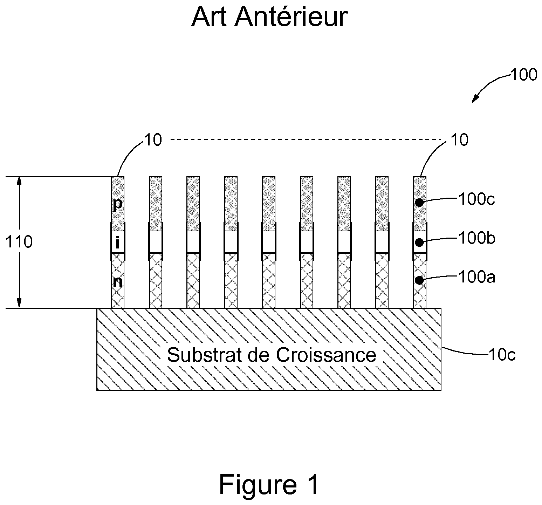

La structure d'une telle LED est schématisée sur la figure 1. Les nanofils sont typiquement formés par croissance épitaxiale à partir d'une matrice de germes disposés à la surface d'un substrat dit de croissance 10c.

Des procédés sont largement décrits dans l'état de la technique. On peut notamment se référer au document WO 2004/088755 A1.

Chaque LED 10 est alors constituée d'un nanofil fait d'un ou plusieurs matériaux semi-conducteur dont on peut faire varier le type et le niveau dopage au cours de la croissance. Le plus couramment on cherche à obtenir une diode dite PIN faite d'un même matériau semi-conducteur caractérisée par une première partie 100a, directement en contact avec le substrat de croissance 10c, dopée de type n, c'est-à-dire à l'aide d'un dopant approprié du semi-conducteur qui permet de développer un mode de conduction par excès d'électrons. Une deuxième partie intermédiaire 100b, qui est dite intrinsèque, c'est-à-dire non intentionnellement dopée, est le siège de la production de photons lumineux résultant de la recombinaison des porteurs électriques injectés depuis la première partie 100a et la troisième partie 100c sous l'effet de l'application d'une tension électrique destinée à faire circuler un courant dans chacun des nanofils. La troisième partie 100c de chaque nanofil est dopée de type p, c'est-à-dire à l'aide d'un dopant approprié du semi-conducteur permettant de développer un mode de conduction par carence d'électrons.

Les nanofils sont typiquement constitués par croissance épitaxiale, à partir du substrat 10c, de matériaux semi-conducteurs composites binaires, dits III-V, comme par exemple le nitrure de gallium (GaN), le phosphure de gallium (GaP), l'arséniure de gallium (GaAs), ou II-VI, comme l'oxyde de Zinc (ZnO).

Chaque nanofil peut être considéré comme un guide d'ondes. Compte tenu de sa forme quasi cylindrique, de sa taille et de son indice de réfraction plus grand que le milieu ambiant, le guidage de la lumière est réalisé sensiblement parallèlement à l'axe de croissance des nanofils. La lumière arrive ainsi à l'extrémité des nanofils avec un angle faible par rapport à l'axe de celui-ci, c'est-à-dire un angle inférieur à l'angle limite de réflexion totale, ce qui facilite la sortie de la lumière.

La production de masse de telles LEDs nanométriques se heurte à différents problèmes qui ont trait, entre autres, à l'obtention d'une efficacité lumineuse optimale des dispositifs produits en permettant que la lumière émise dans toutes les directions, à partir de la partie intermédiaire 100b de chaque LED, soit effectivement réfléchie dans une direction privilégiée et ne contribue pas ou peu à l'échauffement du dispositif. L'application d'une tension aux bornes de chaque LED doit pouvoir aussi se faire uniformément sur l'ensemble des nanofils et demande l'utilisation de substrats et de structures permettant d'obtenir une faible résistance électrique et donc de faibles pertes électriques pour les alimenter.

Ces problèmes, qui ont reçu une considérable attention de la communauté scientifique impliquée dans la conception et le développement de ces dispositifs, ont vu des progrès importants se réaliser qui permettent d'envisager qu'une production de masse puisse effectivement se mettre en place. Cependant, un problème crucial qui a reçu une bien moindre attention a trait au fait que l'on doit pouvoir également réaliser facilement une isolation électrique parfaite de chacun des nanofils après croissance afin d'éviter tout court-circuit entre eux, ce en dépit des distances souvent nanométriques les séparant et pour toute la durée de vie du dispositif.

Les solutions connues prévoient d'entourer chaque nanofil par un matériau diélectrique. En pratique, on verse sur les nanofils un matériau diélectrique liquide peu visqueux pour qu'il remplisse les espaces entre les nanofils. Pour obtenir une bonne isolation de chaque nanofil, il est nécessaire que le matériau diélectrique remplisse tous les espaces entre les nanofils. L'écoulement du matériau diélectrique s'effectue par gravité. Il s'est avéré que des courts-circuits apparaissent du fait d'un mauvais remplissage des espaces situés entre les nanofils. Le remplissage, gêné par des forces capillaires qui s'opposent à l'écoulement par gravité du matériau diélectrique est parfois imparfait ce qui impose l'utilisation de matériaux diélectriques très faiblement visqueux pour limiter les forces capillaires. Pour assurer la suite du processus de fabrication de la LED et la pérennité du produit, le matériau diélectrique doit alors subir une étape de solidification.

Les solutions connues pour solidifier le matériau diélectrique prévoient typiquement une réticulation thermique ou une réticulation par application d'un rayonnement ultraviolet. Dans le cadre du développement de la présente invention il a été constaté que ces solutions de réticulation génèrent d'importantes contraintes thermiques et/ou optiques qui entament le budget thermique et/ou optique de l'ensemble de la structure. Il a même été constaté que ces contraintes peuvent dégrader les performances de la structure.

Le document WO 2009/135078 A2 divulgue un procédé de fabrication d'un dispositif optoélectronique impliquant le transfert d'une pluralité de nanofils semi-conducteurs dans une matrice de destination pouvant être soit conductrice (électriquement ou thermiquement), soit isolante.

L'invention vise à proposer une solution permettant d'assurer une bonne isolation électrique des fils tout en permettant de réduire les contraintes thermiques et/ou optiques subies par la structure.

Les autres objets, caractéristiques et avantages de la présente invention apparaîtront à l'examen de la description suivante et des dessins d'accompagnement. Il est entendu que d'autres avantages peuvent être incorporés dans le cadre toutefois défini par les revendications qui définissent l'étendue de la présente invention.

### RÉSUMÉ DE L'INVENTION

La présente invention porte sur un procédé selon la revendication 1 en annexe, de réalisation d'un dispositif microélectronique comprenant une pluralité de diodes électroluminescentes comprenant chacune un fil de taille nanométrique ou micrométrique, le procédé comprenant :
- une étape de croissance des fils à partir d'un substrat de croissance, lesdits fils s'étendant depuis le substrat de croissance et selon une direction sensiblement perpendiculaire au substrat de croissance,
- une étape de formation d'au moins une première électrode recouvrant un substrat de report distinct du substrat de croissance,
- une étape de formation d'au moins une couche diélectrique sur la première électrode,
- une étape de formation d'au moins une deuxième électrode sur la couche diélectrique, de sorte que la couche diélectrique est disposée entre la première électrode et la deuxième électrode, et
- une étape de pénétration des fils dans la couche diélectrique faisant suite à l'étape de formation de l'au moins une deuxième électrode.

La présente invention porte également sur un jeu d'ensembles multicouches selon la revendication 17 en annexe, ce jeu comprenant:
- au moins un premier ensemble multicouche comprenant un substrat de croissance et une pluralité de diodes électroluminescentes comprenant chacune un fil de taille nanométrique ou micrométrique s'étendant depuis le substrat de croissance et selon une direction sensiblement perpendiculaire au substrat de croissance, et
- au moins un deuxième ensemble multicouche distinct du premier ensemble multicouche, le deuxième ensemble multicouche comprenant un substrat de report surmonté successivement d'une première électrode, d'une couche diélectrique et d'une deuxième électrode, de sorte que la couche diélectrique est disposée entre les première et deuxième électrodes,
les premier et deuxième ensembles multicouches étant configurés de sorte que leur imbrication permet aux fils de pénétrer dans la couche diélectrique, en ayant ladite première électrode en contact avec au moins certains des fils et, en ayant ladite deuxième électrode en contact avec au moins certains des fils.

D'autres modes avantageux de réalisation de la présente invention sont l'objet des revendications dépendantes en annexe.

Ainsi, le procédé selon la présente invention prévoit la réalisation de deux ensembles distincts : le premier ensemble comprenant les fils et le substrat de croissance et le deuxième ensemble comprenant la couche diélectrique surmontant le substrat de report. Les deux ensembles sont ensuite imbriqués l'un dans l'autre de sorte que les fils se retrouvent plongés dans la couche de diélectrique. Ces derniers se trouvent ainsi moulés ou insérés de manière forcée dans la couche diélectrique.

Tous les espaces entre les fils sont ainsi remplis par le matériau diélectrique de la couche diélectrique. Les fils sont ainsi parfaitement isolés.

Ce procédé permet en outre d'utiliser des matériaux moins liquides que ceux auxquels l'on doit obligatoirement recourir avec les solutions connues pour assurer une isolation satisfaisante. En utilisant des matériaux moins visqueux, il est alors possible de réduire significativement, voire de supprimer, les contraintes thermiques et/ou optiques qu'exigent les solutions connues pour parvenir à réticuler le matériau diélectrique. Le budget thermique et/ou optique de l'ensemble de la structure est alors mieux préservé, c'est-à-dire que la capacité de la structure à ne pas s'altérer sous l'effet de contraintes optiques ou thermiques (typiquement une température appliquée pendant un temps donnée) est mieux conservée. Il sera alors possible d'effectuer les étapes suivantes du procédé avec plus de liberté concernant les contraintes imposées à la structure. En outre les performances finales de la structure ne seront pas dégradées du fait des contraintes appliquées durant les étapes de réticulation.

Outre cet avantage lié à la conservation du budget thermique et/ou optique de l'ensemble de la structure, le procédé selon l'invention offre de nombreux autres avantages. En particulier, l'invention permet de réduire les contraintes mécaniques imposées aux LEDs lors de la réticulation. Ces contraintes mécaniques sont souvent en effet d'autant plus fortes que le matériau diélectrique est liquide avant réticulation.

En outre, le procédé selon l'invention permet de réduire le risque d'enrobage complet des fils. Dans les solutions connues, ce risque d'enrobage des fils impose d'effectuer des étapes additionnelles de procédé afin de dégager les extrémités des fils pour assurer leur connexion avec les électrodes. Ces étapes additionnelles rendent le procédé plus complexe et coûteux. L'invention permet également de réduire le risque de création de lacunes, c'est-à-dire d'absence de recouvrement des fils à l'interface fil/diélectrique ou à l'interface fil/support/diélectrique.

Le procédé selon l'invention comprend, préalablement à l'étape de formation de la couche diélectrique, l' étape de formation d'une première électrode au moins sur le substrat de report, de sorte à ce qu'après l'étape de formation de la couche diélectrique, la première électrode est disposée entre le substrat de report et la couche diélectrique.

Toujours selon l'invention, le procédé de réalisation du second ensemble, c'est-à-dire l'ensemble comprenant le substrat de report, comprend une étape de formation d'une deuxième électrode disposée sur la couche diélectrique.

Encore selon l'invention, le deuxième ensemble multicouche comprend la première électrode qui recouvre au moins partiellement le substrat de report et qui est surmontée de la couche diélectrique.

Toujours selon l'invention, le deuxième ensemble multicouche comprend la deuxième électrode recouvrant au moins partiellement la couche diélectrique, de sorte que la couche diélectrique est disposée entre les première et deuxième électrodes.

De manière plus générale, le procédé selon l'invention permet d'améliorer l'isolation électrique des fils tout en permettant d'élargir le choix de matériaux diélectriques. En effet, alors qu'avec les solutions connues le choix des matériaux diélectriques qui peuvent être utilisés est limité puisque seuls des matériaux diélectriques très liquides peuvent être versés sur les fils, l'invention permet d'utiliser des matériaux significativement plus visqueux. La viscosité maximale correspond seulement à la limite de la tenue mécanique des fils lors de l'insertion des fils dans le matériau diélectrique.

De manière facultative, le procédé selon l'invention peut comprendre au moins l'une quelconque des étapes et caractéristiques optionnelles suivantes.

Avantageusement, l'étape de pénétration est effectuée de sorte que les fils traversent totalement la couche diélectrique. Cette caractéristique est particulièrement avantageuse puisqu'elle permet de simplifier l'isolation des fils. En effet, dans les procédés connus rappelés ci-dessus, le dépôt en phase liquide ou en phase vapeur d'une couche de diélectrique autour des fils crée le risque d'un enrobage ou d'un recouvrement complet des fils ou de certains fils. Cet enrobage non souhaité requiert une étape supplémentaire de dégagement des extrémités des fils pour assurer un contact électrique. En outre, l'invention permet un meilleur contrôle de l'homogénéité et de l'épaisseur de la couche diélectrique.

De manière préférée, l'étape de pénétration comprend l'application sur l'un parmi le substrat de croissance ou le substrat de report d'une force de pressage appliquée selon une direction sensiblement parallèle à la direction longitudinale des fils. On désigne direction longitudinale des fils la direction selon laquelle les fils présentent une dimension maximale.

La force de pressage présente une amplitude telle que la contrainte exercée par certains au moins des fils sur la couche de diélectrique est supérieure à la limite plastique de la couche de diélectrique.

Typiquement, la première électrode est une couche de matériau conducteur d'électricité ou de matériau semi-conducteur ou une couche de résine.

Selon un mode de réalisation avantageux, la première électrode recouvre totalement la couche diélectrique. Ce procédé a notamment pour avantage d'être particulièrement simple. Préférentiellement, la première électrode recouvre également la totalité du substrat de report.

Selon un autre mode de réalisation avantageux, la première électrode recouvre partiellement la couche diélectrique. Préférentiellement, la première électrode recouvre une partie seulement du substrat de report. Ainsi, la première électrode peut assurer un routage ou une fonction électrique. Avantageusement, on peut ainsi définir des groupes de fils pour ajuster la puissance lumineuse et/ou la couleur et/ou la thermique du rayonnement lumineux émis par le dispositif. On peut également prévoir une redondance de LEDs pour gérer des cas de défaillance de certaines des LEDs.

Lors de l'étape de pénétration au moins certains des fils entrent en contact avec la première électrode. Plus précisément, au moins une partie de la deuxième partie des fils entre au contact de la première électrode.

Avantageusement, au moins la première électrode présente une certaine ductilité et l'ajustement de son épaisseur permet de compenser d'éventuelles différences de longueur de fils.

Selon un mode de réalisation particulier, on forme, entre la première électrode et le substrat de report une couche additionnelle assurant une compensation de la variabilité de la longueur des fils. De manière particulièrement avantageuse, cette couche de compensation est distincte et indépendante de la première électrode. Cette couche de compensation présente l'avantage de permettre la formation d'une première électrode de faible épaisseur quelles que soient l'amplitude et la variabilité de longueur des fils. L'épaisseur de cette couche de compensation est de préférence supérieure à l'amplitude maximale de différence de longueur entre fils. Ainsi, tous les fils, quelle que soit leur taille, ont une extrémité située dans la couche de compensation. Cette couche de compensation est par exemple réalisée en résine. Le contact électrique peut alors être réalisé de manière périphérique, c'est-à-dire au niveau de l'enveloppe périphérique des fils et non pas au niveau de leur extrémité. Ce mode de réalisation est particulièrement avantageux si la longueur des fils présente une forte dispersion.

Dans un mode de réalisation particulier, la couche additionnelle est disposée au contact du substrat.

Selon la présente invention, la première électrode, la couche diélectrique et la deuxième électrode sont formées avant l'étape de pénétration des fils dans lesdites couches. L'invention permet un procédé fiable, assurant la pénétration des fils dans les diverses couches, de manière homogène et uniforme. En outre, l'invention propose un procédé simple, rapide, fiable et peu coûteux.
Lorsque le matériau formant l'électrode est un matériau conducteur d'électricité ou un matériau semi-conducteur, alors il est avantageusement déposé par déposition en phase vapeur impliquant une réaction chimique ou par un simple dépôt physique, ces deux techniques étant habituellement désignées par les acronymes de CVD et PVD respectivement, de l'anglais « chemical vapor déposition » et « physical vapor déposition ».
Lorsque le matériau formant l'électrode est une résine, alors il peut être déposé par centrifugation.

Avantageusement, le substrat de report peut être réalisé dans un matériau pris parmi : le silicium (Si), le germanium (Ge), des métaux, le verre, le saphir.

Dans la présente invention, les substrats peuvent être rigides ou souples, plans ou non plans.

Avantageusement, l'étape de croissance est réalisée par épitaxie.

Avantageusement, l'étape de croissance est effectuée de sorte que chaque fil présente :
- une première partie en matériau semi-conducteur présentant un premier dopage, ladite première partie étant en contact avec le substrat de croissance ;
- une deuxième partie en matériau semi-conducteur intrinsèque, ladite deuxième partie étant disposée sur ladite première partie;
- une troisième partie en matériau semi-conducteur présentant un deuxième dopage.

Selon un premier mode de réalisation, ladite troisième partie est disposée sur ladite deuxième partie. Ainsi, la deuxième partie est située entre les première et deuxième parties. Cette structure est dite axiale.

Selon un deuxième mode de réalisation, ladite deuxième partie recouvre une partie au moins des flancs de la première partie et ladite troisième partie recouvre une partie au moins des flancs de la deuxième partie. Ainsi, la deuxième partie englobe une partie au moins de la première partie et ladite troisième partie englobe une partie au moins des première et deuxième parties. Cette structure est qualifiée de cœur-coquille.

Dans ce mode de réalisation, une extrémité de la première partie est englobée par la deuxième partie et par la troisième partie.

Préférentiellement, la somme des épaisseurs de la première électrode, de la couche diélectrique et de la deuxième électrode est inférieure ou égale à une hauteur de certains au moins des fils. On définit la hauteur des fils par la somme des hauteurs des première, deuxième et troisième parties des fils. La hauteur est la dimension séparant la base du fil, c'est-à-dire son extrémité en contact avec le substrat de croissance, de son extrémité libre.

Préférentiellement, la couche diélectrique est une couche de résine déposée par centrifugation ou spin coating.

Avantageusement, la couche diélectrique présente une épaisseur comprise entre la hauteur des fils et la distance séparant la première partie de la troisième partie. L'épaisseur de la couche de diélectrique est ainsi au moins égale à la hauteur de la troisième partie des fils. De préférence, elle est supérieure à la hauteur des deuxième et troisième parties des fils. Ainsi, l'isolation des fils est efficace tout en ménageant un accès aisé à l'extrémité des fils pour effectuer les connexions.

Par exemple, la couche diélectrique présente une épaisseur comprise entre 10 nm et 500 µm et de préférence inférieure à 100 µm et de préférence supérieure à 100 nm.

Le diamètre typique d'un fil est de quelques dizaines à quelques centaines de nanomètres, tandis que sa hauteur totale est 10 nm à 100 µm.

Avantageusement, le procédé comprend, après l'étape de pénétration, une étape de décrochage du substrat de croissance au cours de laquelle on retire le substrat de croissance tout en laissant les fils partiellement au moins à l'intérieur de la couche diélectrique.

De manière alternative, le substrat de croissance forme une couche mince d'un matériau semi-conducteur surmontant une couche isolante qui surmonte elle-même un substrat receveur. Avantageusement, le procédé comprend alors, après l'étape de pénétration, une étape de décrochage du substrat de report au cours de laquelle on retire le substrat de report tout en laissant en place la couche diélectrique à l'intérieure de laquelle les fils sont contenus au moins partiellement.

Avantageusement, l'empilement de couches formé par la couche mince, la couche isolante et le substrat receveur forme un empilement de type silicum sur isolant (SOI).

De préférence, au cours de l'étape de décrochage, on applique au moins une force de retrait, sensiblement parallèle à la direction longitudinale des fils.

Selon un mode de réalisation avantageux, l'étape de décrochage comprend une application, sur l'un parmi le substrat de croissance ou le substrat de report, d'une force principale appliquée selon une direction sensiblement orthogonale à la direction longitudinale des fils et comprend : soit l'application sur l'autre parmi le substrat de croissance ou le substrat de report d'une autre force appliquée selon une même direction que celle de la force principale et selon un sens inverse à celle de la force principale, soit le maintien de l'autre parmi le substrat de croissance ou le substrat de report.

Ainsi, l'étape de décrochage comprend l'application d'un effort de cisaillement selon une direction sensiblement perpendiculaire à une direction principale selon laquelle les fils s'étendent, cet effort tendant à séparer le substrat de croissance de l'ensemble formé par les fils insérés dans la couche diélectrique.

De manière alternative, l'étape de décrochage comprend une application, sur l'un parmi le substrat de croissance ou le substrat de report d'un couple principal de torsion autour d'un axe sensiblement parallèle à une direction longitudinale des fils et comprend : soit l'application sur l'autre parmi le substrat de croissance ou le substrat de report d'un autre couple appliquée autour d'un même axe que celui du couple principal et selon un sens inverse à celui du couple principal, soit le maintien de l'autre parmi le substrat de croissance ou le substrat de report.

Ainsi, l'étape de décrochage comprend une application d'un couple de torsion autour d'un axe sensiblement parallèle à la direction de longueur maximale de la pluralité des fils, ce couple tendant à séparer le substrat de croissance de l'ensemble formé par les fils insérés dans la couche diélectrique.

Selon un mode particulier, l'étape de décrochage comprend une étape d'application d'ondes ultrasonores ou de vibrations. La fréquence des ondes ultrasonores ou des vibrations est choisie de sorte à être une fréquence de résonance de la pluralité de fils.

Les fils sont des nanofils ou des microfils. Ils présentent une longueur inférieure à 500 micromètres et de préférence inférieure à 100 µm.

Selon la présente invention, les fils s'étendent selon une direction sensiblement perpendiculaire à la surface du substrat de croissance. Ainsi tous les fils s'étendent selon une direction commune. Ils forment ainsi une forêt de fils. Un ensemble formé par une couche de croissance ou un substrat de croissance et surmonté de fils forme un ensemble multicouche. Typiquement, une forêt de fils présente une densité comprise entre 10⁴, soit 10000 et 10¹¹ par centimètres carrés. Typiquement, chaque fil présente une section circulaire dont le diamètre est compris entre 10 nm et 100 µm.

De manière optionnelle mais particulièrement avantageuse, on effectue une solidification de la couche diélectrique après l'étape de pénétration, dite aussi de moulage.

De manière optionnelle mais particulièrement avantageuse, on procède : à un décrochage du substrat de croissance de la forêt de fils ; à un démoulage partiel du deuxième ensemble dans lequel on retire le substrat de croissance et on laisse en place la pluralité de fils.

De manière alternative, on laisse en place une partie au moins du substrat de croissance et on décroche le substrat de report.

Avantageusement, chaque fil forme une diode électroluminescente.

Selon un autre aspect, l'invention porte sur un jeu d'ensembles multicouches comprenant au moins un premier ensemble multicouche comprenant un substrat de croissance et une pluralité de diodes électroluminescentes comprenant chacune un fil de taille nanométrique ou micrométrique s'étendant depuis le substrat de croissance et selon une direction sensiblement perpendiculaire au substrat de croissance, et comprenant également au moins un deuxième ensemble multicouche distinct du premier ensemble multicouche, le deuxième ensemble multicouche comprenant un substrat de report surmonté successivement d'une première électrode, d'une couche diélectrique et d'une deuxième électrode, de sorte que la couche diélectrique est disposée entre les première et deuxième électrodes, les premier et deuxième ensembles multicouches étant configurés de sorte que leur imbrication permet aux fils de pénétrer dans la couche diélectrique, en ayant ladite première électrode en contact avec au moins certains des fils et, en ayant ladite deuxième électrode en contact avec au moins certains des fils.

Plus précisément, les premier et deuxième ensembles multicouches sont configurés de sorte que leur imbrication permet aux fils de pénétrer dans la couche diélectrique lorsque cette dernière n'est pas réticulée ou présente une viscosité inférieure à la limite de déformation plastique des fils.

Dans la réalisation illustrée, des fils de Si ont été transférés dans une résine dont le module de Young est E = 10⁶ Pa, la viscosité est nu = 10⁷ Pa.s. La pression appliquée est de 15 bars.

De manière générale, il n'y a pas de seuil minimal de viscosité de la couche de diélectrique pour pouvoir appliquer l'invention. Le seuil de viscosité maximal dépend quant à lui de la limite de déformation élastique des fils. Il faut que la pression appliquée aux fils lors du moulage pour vaincre la viscosité du diélectrique reste inférieure à la limite de déformation élastique. Donc cela dépend du matériau des fils (GaN, ZnO, ....) et de leurs topologie et typologie (pression résultante sur les fils).

De manière facultative, le jeu d'ensembles multicouches selon l'invention peut comprendre au moins l'une quelconque des caractéristiques optionnelles suivantes.

La longueur de certains au moins des fils est supérieure ou égale à l'épaisseur de la couche diélectrique et la couche diélectrique présente une épaisseur comprise entre la distance séparant les première et troisième parties et 100% de la hauteur des fils les plus hauts.

Ainsi, les premier et deuxième ensembles multicouches sont configurés de sorte que le pressage d'un ensemble multicouche dans l'autre ensemble multicouche permet aux fils de traverser de part en part la couche diélectrique.

Selon un mode de réalisation avantageux, le substrat de croissance est un ensemble multicouche de type silicium-sur-isolant (SOI).

Préférentiellement, chaque fil du premier ensemble multicouche présente :
- une première partie en matériau semi-conducteur présentant un premier dopage, ladite première partie étant en contact avec le substrat de croissance ;
- une deuxième partie qui correspond à la zone active dans laquelle vont se produire les recombinaisons paire e-/trou. Elle peut par exemple être formée en matériau semi-conducteur intrinsèque, ladite deuxième partie étant disposée sur ladite première partie;
- une troisième partie en matériau semi-conducteur présentant un deuxième dopage, le deuxième dopage étant opposé au premier dopage, ladite troisième partie étant disposée sur ladite deuxième partie.

Ainsi, la deuxième partie dite active est située entre les première et troisième parties.

Selon l'invention telle que définie par les revendications en annexe, les premier et deuxième ensembles multicouches sont configurés de sorte que lorsqu'ils sont imbriqués, la première électrode est en contact avec au moins certains des fils.

Toujours selon l'invention, les premier et deuxième ensembles multicouches sont configurés de sorte que lorsqu'ils sont imbriqués, la deuxième électrode est également en contact avec au moins certains des fils.

Avantageusement, la couche diélectrique est disposée au contact direct de la première électrode et la deuxième électrode. Dans un mode de réalisation particulier, la première électrode est disposée au contact du substrat ou au contact de la couche additionnelle de compensation.

Avantageusement, la troisième partie de certains des fils au moins et la première partie au moins sont en contact avec respectivement la première électrode et la deuxième électrode.

Avantageusement, la couche diélectrique est une couche de résine réalisée en matériau polymère. Avantageusement, ledit matériau polymère est du polyhydroxystyrène ou du type méthacrylate.

Dans le cadre de la présente invention, le diamètre des fils est inférieur à la hauteur. Il faut de préférence que le rapport du diamètre sur la hauteur soit inférieur à 1/5 ou 1/10, afin notamment de percer la couche plus aisément. Par exemple, la hauteur des fils est comprise entre 100 nm et 500 µm.

### BRÈVE DESCRIPTION DES FIGURES

Les buts, objets, ainsi que les caractéristiques et avantages de l'invention ressortiront mieux de la description détaillée des modes de réalisation de cette dernière qui sont illustrés par les dessins d'accompagnement suivants dans lesquels :
La FIGURE 1 est une vue en coupe d'une structure nanofilaire ou microfilaire traditionnelle, comprenant un substrat de croissance et des nanofils ou microfils adaptés à la production de diodes électroluminescentes ou LEDs, et servant de moule d'impression dans le cadre du procédé de l'invention.
Les FIGURE 2a à 2d sont des vues en coupe décrivant des structures d'un substrat de report comprenant au moins une couche diélectrique servant à l'isolation des LEDs nanofilaires ou microfilaires.
Les FIGURE 3a à 3d décrivent les étapes du procédé selon la présente invention qui utilise le moule d'impression comprenant les fils pour les isoler en les imprimant dans la couche diélectrique du substrat de report.
La FIGURE 4 illustre le comportement général d'un matériau soumis à une contrainte mécanique.
La FIGURE 5 décrit un mode de mise en oeuvre optionnel de l'invention dans lequel le substrat de croissance est remplacé par un substrat élaboré de type silicium sur isolant (SOI).
La FIGURE 6 décrit un exemple de réalisation particulier, illustratif du contexte de la présente invention mais ne la définissant pas à lui seul, dans lequel on introduit une couche additionnelle de compensation pour tenir compte de la variabilité de la longueur des fils.
La FIGURE 7 illustre un deuxième mode de réalisation des fils, de type en l'occurrence « cœur-coquille ».
La FIGURE 8 montre l'imbrication de la structure de fils de type cœur-coquille dans l'ensemble formé sur le substrat de report.
La FIGURE 9 résume les étapes du procédé de l'invention.

Les dessins joints sont donnés à titre d'exemples et ne sont pas limitatifs de l'invention, laquelle est définie par les revendications en annexe.

### DESCRIPTION DÉTAILLÉE DE L'INVENTION

Il est précisé que dans le cadre de la présente invention, le terme « sur » ne signifie pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la suite de la description on utilisera le terme de fil pour désigner des fils de taille nanométrique ou micrométrique. Typiquement, la longueur des fils est inférieure au 1 millimètre et de préférence inférieure à 500 micromètres et leur diamètre est inférieur au cinquième de leur hauteur. Tout au long de la description, les termes fils peuvent donc être lus nanofils ou microfils.

Comme décrit brièvement précédemment dans le chapitre sur l'état de la technique, et comme illustré à la figure 1, il faut pouvoir mettre électriquement en parallèle une multitude de fils (nanofils ou microfils), chacun constituant une LED indépendante, tout en assurant une connexion électrique la meilleure possible avec les extrémités des première 100a et troisième 100c parties de chacun des fils lesquelles constituent, respectivement, cathode et anode des LEDs. Typiquement, de cent mille à dix millions de LEDs filaires doivent pouvoir ainsi être connectées et parfaitement isolées les unes des autres, et entre cathodes et anodes, afin d'éviter tout court-circuit.

L'isolation, qui doit se pratiquer après croissance des fils, oblige actuellement à utiliser un diélectrique qui doit être disponible sous forme liquide. On dépose alors le diélectrique sur la « forêt » de fils afin qu'il puisse pénétrer complètement par gravité tous les interstices sous jacents entre les fils.

L'inconvénient de la technique traditionnelle exposée ci-dessus est que selon la densité des fils il devient alors parfois impossible de faire pénétrer complètement, par gravitation, le diélectrique dans les interstices de tailles nanométriques entre fils car les forces de capillarité peuvent être alors prédominantes. Si le diélectrique que l'on souhaite utiliser a une trop forte viscosité au regard de la densité des fils et de leur espacement, le liquide ne pénètre pas ou peu la forêt de fils. Les forces de capillarité sont prédominantes sur la gravité et empêchent la pénétration. Ceci limite grandement le champ des matériaux diélectrique utilisables, non seulement à ceux qui présentent une phase liquide lors de la mise en oeuvre, mais de plus, parmi ceux-ci, à ceux qui sont d'une fluidité suffisante vis-à-vis de la densité de la forêt de fils qu'il faut pouvoir isoler électriquement. D'autre part le contrôle du mouillage des fils et/ou du remplissage des interstices par le matériau diélectrique impacte la conformité du dépôt et nécessite des étapes technologiques ultérieures, comme par exemple un « polissage mécano chimique » ou CMP, acronyme de l'anglais « chemical mechanical polishing ».

L'invention permet de s'affranchir de cette contrainte en préparant sur un substrat de report, distinct du substrat de croissance, un film diélectrique d'un matériau dont les propriétés physico chimiques seront en particulier choisies en fonction de leur fonction première qui est d'obtenir la meilleure isolation possible entre fils.

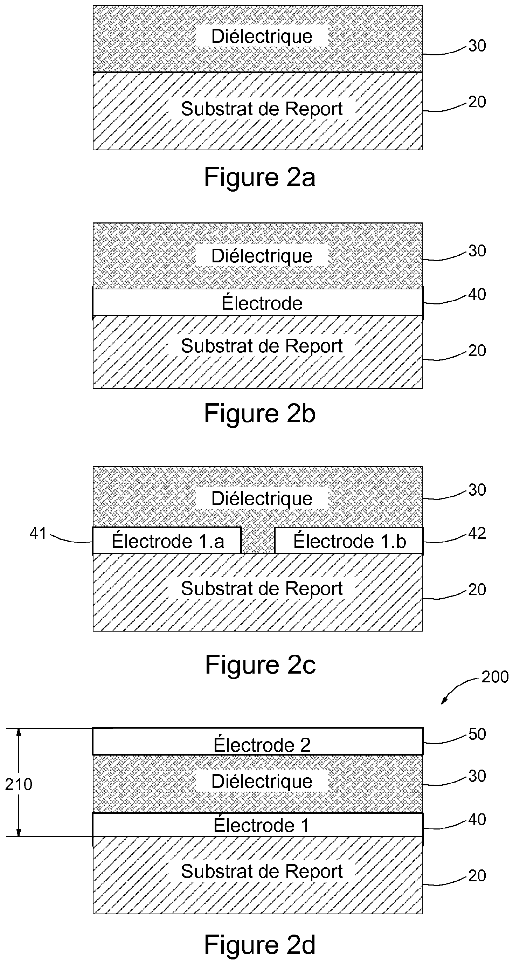

Différentes structures d'un substrat de report sont présentées dans les **figures 2a à 2d** qui illustrent des vues en coupe d'un ensemble multicouche comprenant un substrat de report sur lequel est présente au moins la couche diélectrique destinée à isoler les fils.

Dans sa forme la plus simple, illustrée par la **figure 2a****,** le substrat de report 20 n'a qu'une fonction mécanique de support de la couche diélectrique 30 qui va seulement être utilisée pour l'isolation des fils qu'on a fait croître par ailleurs sur un substrat de croissance.

Selon un mode particulier de mise en oeuvre de l'invention le substrat de report 20 peut être fait de matériaux très divers incluant : le silicium (Si), le germanium (Ge), des métaux ou le verre et le saphir.

La couche diélectrique 30 est déposée de façon conventionnelle par centrifugation ou « spin coating » s'il s'agit d'une résine. Typiquement, la résine utilisée est alors un matériau polymère qui est composé de chaînes de type polyhydroxystyrène (PNS) ou de type méthacrylathe, c'est-à-dire des résines de du genre polyméthylmétacrylate de méthyle (PMMA). Après dépôt de la résine, on procède à un recuit afin d'évaporer le solvant résiduel présent dans le matériau pour stabiliser la tenue thermique et mécanique du matériau.

D'autres moyens couramment mis en oeuvre par l'industrie de la microélectronique peuvent être utilisés pour d'autres matériaux diélectriques en particulier ceux disponibles sous forme solide, comme par exemple les dépositions en phase vapeur impliquant une réaction chimique ou un simple dépôt physique respectivement désignées par les acronymes de CVD et PVD de l'anglais « chemical vapor déposition » et « physical vapor déposition ».

La **figure 2b** illustre une structure alternative plus élaborée dans laquelle on introduit entre le substrat de report 20 et la couche diélectrique 30 une couche 40 destinée à assurer l'interconnexion électrique des parties supérieures des fils formant les LEDs. Ces parties comprennent l'extrémité libre des fils lorsqu'ils sont sur leur substrat de croissance. Elles sont référencées 100c sur la figure 1. La couche 40 est destinée comme on va le voir plus loin à former une première électrode, ou électrode de tête, du dispositif à base de LEDs filaires. Une fonction de la couche 40 formant la première électrode est d'assurer une répartition électrique homogène de la tension appliquée sur l'ensemble des fils. Elle devra donc avoir en général une résistance électrique faible. Cette propriété peut être obtenue en coopération avec le substrat de report 20, qui sert alors de contact électrique, s'il reste en place dans le dispositif final.

La couche 40 pourra être déposée à l'aide des moyens déjà cités ci-dessus : par centrifugation, CVD ou PVD selon le type de matériau employé dont on trouvera une liste non exhaustive ci-après avec la description de la figure 2d. Typiquement, l'épaisseur déposée est comprise dans une gamme allant de quelques nanomètres (10⁻⁹ mètres) à plusieurs micromètres.

Optionnellement, le substrat de report 20 pourra être retiré dans le dispositif final en mettant en oeuvre différentes techniques connues : par attaque chimique ou mécano chimique (CMP) ou encore par soulèvement à l'aide d'un laser, technique le plus souvent référencée par son appellation anglaise de « laser lift-off » ou LLO.

La **figure 2c** illustre un cas où le substrat de report 20 est un substrat fonctionnel qui comporte déjà des fonctions électroniques nécessaires au fonctionnement des LEDs filaires. En maîtrisant l'alignement des fonctions électroniques sur les fils on peut alors créer des groupes de LED nanométriques indépendantes dans le but, par exemple, d'ajuster la puissance lumineuse du dispositif, sa couleur, le comportement thermique du composant final ou encore pour gérer la redondance des LEDs en cas de défaillance de certaines d'entre elles. L'électrode 40 est alors fractionnée en autant de zones électriquement indépendantes que nécessaires, comme par exemple 41 et 42, afin de délimiter des composants ou parties de composants et des bouquets de fils.

La **figure 2d** illustre une structure selon la présente invention, dans laquelle on introduit dans l'ensemble multicouche comportant le substrat de report une seconde couche 50 destinée à l'interconnexion électrique des parties inférieures des fils formant les LEDs, c'est-à-dire celles s'étendant depuis le substrat de croissance. Ces parties inférieures sont référencées 100a sur la figure 1. Cette couche 50 est destinée comme on va le voir plus loin à former une seconde électrode 50, ou électrode de pied, du dispositif à base de LEDs filaires. Comme pour la première couche 40, une fonction de la couche 50 formant la seconde électrode est d'assurer une répartition électrique homogène de la tension appliquée sur l'ensemble des fils et donc de présenter une faible résistance électrique.

Les matériaux utilisés pour les première et seconde couches d'interconnexion, déposés avec les moyens mentionnés précédemment, sont par exemple : des métaux couramment utilisés pour la fabrication des diodes électroluminescentes, tels l'argent (Ag), le platine (Pt), le palladium (Pd) ou l'or (Au) ; d'autres matériaux utilisés couramment par l'industrie des semi-conducteurs comme l'oxyde de nickel (NiO) ou un matériau transparent, électriquement conducteur, comme l'oxyde d'indium et d'étain (ITO) ; ou encore des polymères conducteurs comme ceux utilisés pour les LEDs faites de matériaux organiques (OLEDs).

Typiquement, l'épaisseur déposée pour former la couche 50 est comprise dans une gamme allant de quelques nanomètres à quelques dizaines de nanomètres. Il est important de noter que le dépôt de la couche 50 doit se faire sans altération de la couche diélectrique sous jacente. En particulier, si le matériau diélectrique utilisé est une résine, le moyen de dépôt employé pour la couche 50 ne doit pas faire que la température excède la température de transition vitreuse (Tg) de celle-ci de façon à ce que le dépôt se fasse sur un matériau polymère solide et non pas dans un état visqueux voire liquide. Pour ce faire, on préférera parmi les moyens de dépôt mentionnés ci-dessus un dépôt de type PVD par pulvérisation cathodique.

L'épaisseur totale 210 de la couche diélectrique et des seconde et première couches destinées à l'interconnexion électrique des fils est adaptée à la hauteur 110 de croissance de ceux-ci comme montré sur la figure 1.

L'ensemble multicouche comprenant le substrat de croissance 10c et les fils 10 est désigné, par la suite, premier ensemble multicouche 100. Ce premier ensemble multicouche 100 peut ne comprendre aucune autre couche que le substrat de croissance et les fils. L'ensemble multicouche comprenant le substrat de report 20 et au moins la couche diélectrique 30 avec également les couches d'interconnexion est désigné, par la suite, deuxième ensemble multicouche. Comme on va le voir ci-après, pour s'affranchir des forces de capillarité qui empêchent un diélectrique insuffisamment fluide de remplir par gravité les interstices entre fils, le procédé de l'invention prévoit que l'on exerce une pression mécanique sur le premier ensemble multicouche, de façon à faire pénétrer les fils 10 complètement dans la couche diélectrique 30, en transperçant la seconde couche d'interconnexion 50 là où elle est présente, jusqu'à venir en contact ou pénétrer au moins en partie la première couche d'interconnexion 40. L'épaisseur totale 210 de la couche diélectrique 30 additionnée des éventuelles couches d'interconnexion 40, 50 ne doit donc pas être supérieure à la hauteur minimale de la forêt de fils.

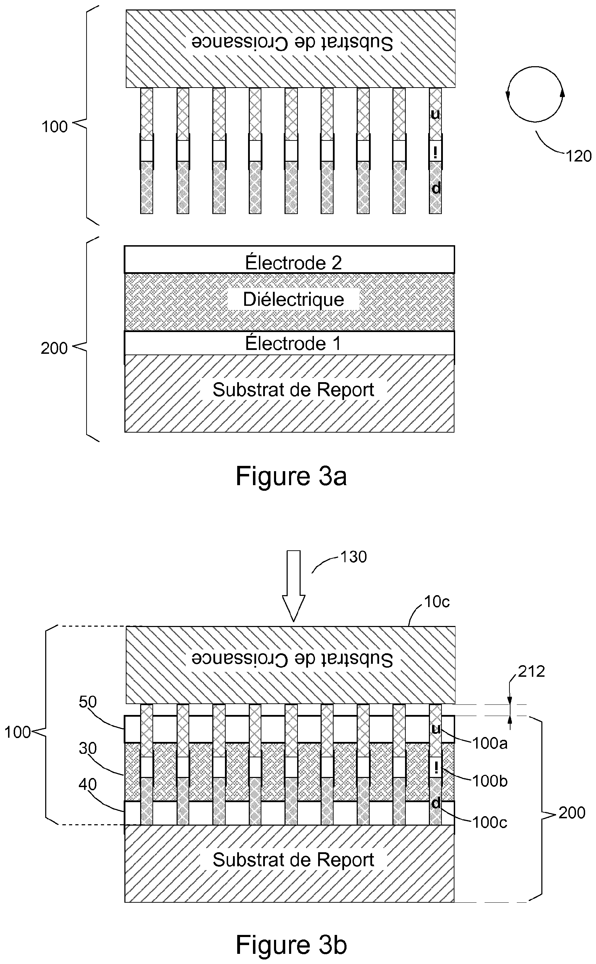

Les **figures 3a à 3d** décrivent les étapes du procédé de l'invention qui utilise le premier ensemble multicouche 100 comprenant le substrat de croissance 10c et les fils 10 comme d'un moule d'impression. L'invention n'est pas limitée à certains matériaux qui composent ce premier ensemble multicouche 100 ni sur la façon dont il a été obtenu séparément du deuxième ensemble multicouche décrit notamment à la figure 2d et qui fait office de pièce moulée.

La **figure 3a** illustre l'étape où les deux ensembles multicouches 100 et 200, qui ont été préparés séparément, vont être assemblés. Comme illustré sur les figures, les fils s'étendent depuis le substrat de croissance 100 selon une direction sensiblement perpendiculaire au substrat de croissance 100. L'ensemble multicouche 100 comprenant le substrat de croissance est retourné, 120, pour être utilisé comme un moule vis-à-vis de l'ensemble multicouche 200 comprenant la couche diélectrique 30, disposée entre l'au moins première électrode 40 (marquée: électrode 1 sur la figure 3a) et l'au moins deuxième électrode 50 (marquée: électrode 2 en figure 3a).

La **figure 3b** montre le résultat de l'étape de moulage au cours de laquelle on fait pénétrer l'ensemble multicouche 100, utilisé comme un moule d'impression, en appliquant une pression mécanique 130 sur celui-ci afin qu'il traverse dans l'ordre, dans l'exemple de la figure 3b selon l'invention où les deux couches d'interconnexion (servant d'électrodes pour les fils) sont présentes : la seconde couche 50 destinée à l'interconnexion électrique des fils et la couche diélectrique 30 jusqu'à venir en contact ou pénétrer au moins partiellement la première couche 40 d'interconnexion afin d'assurer un bon contact électrique avec celle-ci.

L'application d'une force extérieure 130, par exemple à l'aide d'une presse, permet de planter les fils dans la couche diélectrique. L'application de cette force externe autorise l'utilisation d'une gamme plus importante de matériaux isolants, en particulier des matériaux qui présentent des viscosités très élevées. Le remplissage de la forêt de fils par un diélectrique, qui est liquide ou visqueux avant sa stabilisation, n'est plus alors seulement gouverné par la gravité et les forces de capillarité qui peuvent être, comme on l'a déjà vu précédemment, prépondérantes et empêcher son écoulement dans les cavités submicroniques que sont les espaces interstitiels entre les fils. Dans le procédé selon l'invention c'est la pression exercée sur l'ensemble multicouche 100, comprenant le substrat de croissance des fils, utilisé comme moule de nano impression, qui devient prédominante permettant de remplir complètement les espaces interstitiels entre les fils. De manière cumulée ou alternative, on notera qu'une force de pression peut être appliquée, sur le deuxième ensemble multicouche.

Comme mentionné précédemment, l'épaisseur totale 210 des couches diélectrique et de connexion de l'ensemble multicouche 200 est adaptée à la hauteur 110 de croissance des fils. Avantageusement, l'épaisseur totale 210 sera adaptée pour ménager un espace libre 212 au pied des fils afin de faciliter le retrait du substrat de croissance 10c par voie mécanique, chimique ou une combinaison des deux, comme cela est décrit ci-après. Optionnellement, en fonction de modes particuliers de mise en oeuvre de l'invention et des matériaux utilisés, cet espace 212 peut ne pas être nécessaire, voire s'avérer être un inconvénient, et peut être inexistant (ramené à zéro) auquel cas on fait pénétrer le moule 100 jusqu'à ce que le substrat de croissance vienne en contact avec la couche supérieure de l'ensemble multicouche 200, c'est-à-dire la seconde couche 50 d'interconnexion comme représentée sur la figure 3b.

Par ailleurs on notera que les épaisseurs individuelles de la couche diélectrique 30, et des couches d'interconnexions 40 et 50, sont choisies pour que la partie intermédiaire ou seconde partie des fils 100b, fait d'un matériau semi-conducteur intrinsèque, soit toujours entièrement contenu dans la couche diélectrique sur l'ensemble de la forêt de fils du dispositif. D'autre part, le choix des épaisseurs de la couche diélectrique 30 et des couches d'interconnexions 40 et 50 se fait pour que ces deux dernières ne puissent être en contact, exclusivement et complètement, qu'avec, respectivement, les troisième 100c et première 100a parties des fils et sans que nulle part dans la forêt de fils il puisse en être autrement afin d'éviter tout mauvais fonctionnement des LEDs filaires.

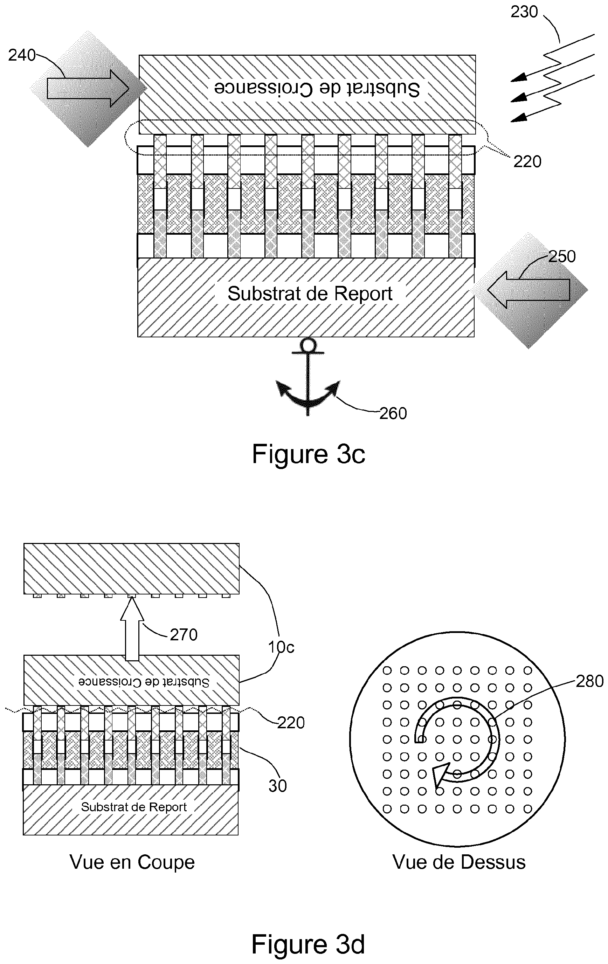

La **figure 3c** illustre l'opération de décrochage mécanique du substrat de croissance. Le décrochage s'opère à partir de la zone de rupture 220 là où l'on a de préférence ménagé l'espace libre 212 mentionné ci-dessus. La fragilisation des pieds des fils dans la zone de rupture se fait en appliquant différents types de contraintes mécaniques, par exemple en appliquant une force de pression ou un choc latéral 240 au substrat de croissance alors que le substrat de report est immobilisé 260. Des forces de pression ou chocs opposés 250 peuvent aussi être appliqués simultanément au substrat de report 20.

Pour faciliter le décrochage, des ultrasons 230 peuvent être générés dans une gamme de fréquence qui va mettre en résonance les pieds des fils. Tous les moyens ci-dessus peuvent être employés conjointement, ou alors seuls ou en combinaison successivement. En fonction des applications particulières du procédé de l'invention un seul de ces moyens pourra suffire pour assurer le décrochage du substrat de croissance.

Avantageusement, l'opération de décrochage ci-dessus se fait après que la couche diélectrique 30 aura été partiellement ou totalement solidifiée ou durcie à l'issue de l'opération de moulage précédente et avant donc d'appliquer les contraintes mécaniques décrites ci-dessus. Les moyens utilisés pour la solidification totale ou partielle de la couche diélectrique dépendent essentiellement des matériaux utilisés. Dans le cas de l'utilisation d'une résine diélectrique, celle-ci peut être réticulée, c'est-à-dire stabilisée par voie thermique ou par exposition à un rayonnement dans l'ultra violet (UV) de durée contrôlée (flash) pour obtenir son durcissement.

La **figure 3d** illustre l'opération de démoulage partiel au cours de laquelle le moule, le substrat de croissance, est séparé du deuxième ensemble multicouche à l'intérieur duquel les fils ont été insérés. Le démoulage partiel consiste à enlever le substrat de croissance 10c seul et à laisser en place les fils devenus prisonniers de la couche diélectrique 30. Comme pour le décrochage, différentes contraintes mécaniques peuvent être appliquées pour obtenir ce résultat. Une force de traction 270, parallèle à la direction longitudinale des fils (soit généralement perpendiculaire au plan du dispositif), peut être appliquée qui va permettre de séparer l'assemblage des deux ensembles multicouches au niveau de la zone de rupture 220. Un mouvement rotatif 280 peut aussi être appliqué simultanément pour obtenir la séparation. Pour le démoulage, de nombreuses techniques sont susceptibles d'être appliquées en particulier celle dites par pelage ou démoulage parallèle.

On notera que le procédé décrit dans les figures 3a à 3d s'applique d'une façon générale à tout type de substrat rigide plan mais aussi possiblement aux supports souples et non plans.

On notera également que le substrat de report peut être conservé. De manière alternative, on peut le supprimer en totalité ou en partie. Selon cette alternative, le substrat de report joue alors un rôle essentiellement mécanique tel une poignée de manipulation.

On notera aussi que dans le cas de l'utilisation d'une résine thermoplastique comme diélectrique ce matériau a un comportement thermique réversible. Il est alors avantageux de ne pas réaliser le procédé d'impression à des températures trop élevées par rapport à la température de transition vitreuse (Tg) de la résine. En effet, les couches métalliques et les matériaux organiques présentent des coefficients de dilatation thermique très différents, typiquement différents d'un ordre de grandeur (x10). Si on applique des températures trop élevées par rapport à Tg, les contraintes mécaniques générées aux interfaces polymère/métal entraînent une rupture du film métallique ce qui est évidemment préjudiciable au bon fonctionnement du dispositif final. Par conséquent, il est avantageux d'imprimer le deuxième ensemble multicouche 200 à une température égale ou inférieure à la température de transition vitreuse du polymère. La force appliquée sera ajustée pour que la contrainte générée par les films au niveau des couches soit suffisante pour engendrer une déformation plastique (et non pas élastique) de l'ensemble multicouche. Pour ce faire, on utilisera les propriétés mécaniques de la couche diélectrique 30 et de la seconde couche d'interconnexion 50 pour évaluer la contrainte mécanique minimale à appliquer. Avantageusement, si la contrainte appliquée par un fil est supérieure à la limite plastique la plus élevée entre celle de la seconde couche d'interconnexion et le matériau diélectrique, on peut générer une déformation permanente dans les couches et donc leur perforation. Cette règle permet en fonction de la densité de fil de connaître la pression qu'il faut appliquer sur la face arrière du moule.

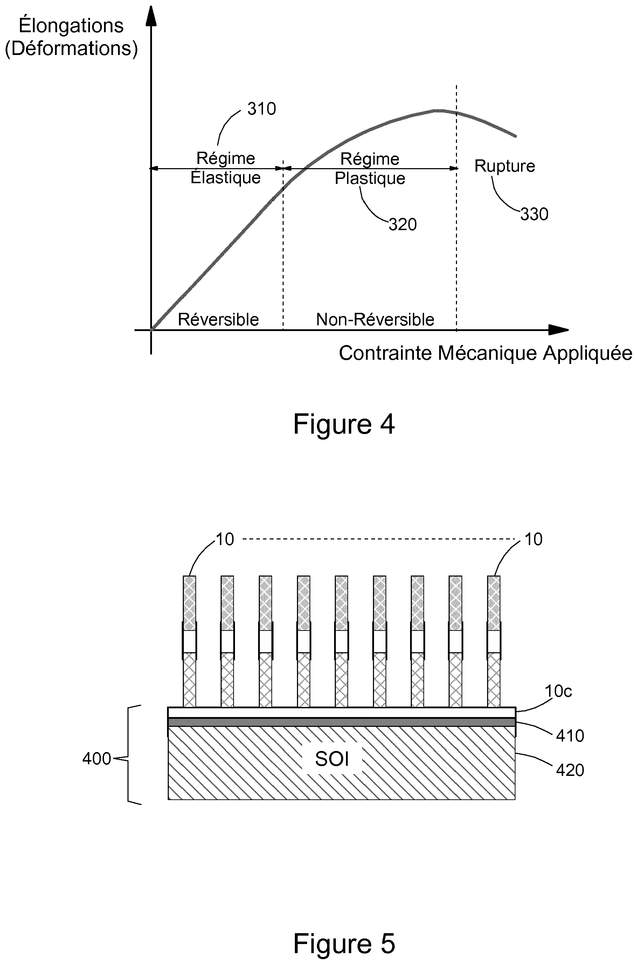

La **figure 4** illustre le comportement général d'un matériau soumis à une contrainte mécanique et montre les différentes zones où les déformations sont successivement réversibles ou élastiques 310, plastiques et non réversibles 320 avant d'atteindre finalement un point de rupture 330.

Par ailleurs, on notera que si on utilise comme diélectrique un matériau organique qui n'est plus thermoplastique mais qui est photo polymérisable à l'aide d'une exposition contrôlée en temps et intensité à des rayonnements ultra violet (flash UV), ou thermodurcissable à l'aide d'une étape de recuit, deux approches sont possibles :
- le dépôt de la seconde couche d'interconnexion 50 se fait après photo polymérisation ou thermo réticulation du matériau diélectrique. Cette étape de stabilisation ou de durcissement pourra être totale ou partielle de telle sorte que le dépôt de la couche 50 soit effectivement possible et que l'on obtienne bien une couche continue d'une rugosité contrôlée et sans craquelure de surface. L'intérêt d'avoir une stabilisation partielle est d'utiliser un matériau qui sera moins rigide et donc plus facilement déformable pour l'étape d'impression (moulage). La stabilisation finale pourra être faite après impression à l'aide d'un flash UV ou après un recuit thermique additionnel.
- on utilise le matériau diélectrique sans réaliser l'étape de stabilisation, même partielle, décrite ci-dessus. Le matériau peut être alors soit liquide ou très visqueux. On s'assurera que le dépôt de la seconde couche d'interconnexion 50 peut néanmoins être effectué sans inconvénient. Si ce n'est pas le cas, on procède alors une étape de pré-stabilisation de la couche diélectrique. Une pré-stabilisation est une étape permettant d'obtenir un matériau diélectrique dans un état intermédiaire, par exemple semi-réticulé. Pour cela, on chauffe à une température de réticulation inférieure et/ou pendant une durée inférieure à celle nécessaire pour réticuler totalement le matériau. Une telle étape permet de ne pas entamer le budget thermique de la structure. Il s'agit d'une étape permettant de mettre le matériau dans un état intermédiaire pour faciliter sa manipulation par exemple, ou pour adapter ses propriétés mécaniques au processus d'impression. Une préstabilisation peut être faite en l'absence des fils. Si l'utilisation de la couche diélectrique est effectivement possible sans stabilisation alors son durcissement se fait pendant la phase d'impression (moulage) et avant séparation des fils du support de croissance afin obtenir une stabilité mécanique de l'ensemble multicouche résultant. On a ainsi deux phases de stabilisation :
   - une phase de pré-stabilisation qui sert à mettre le matériau dans un état intermédiaire permettant sa manipulation et/ou le dépôt de couches complémentaires. Par exemple, on procède au dépôt du matériau sous une forme liquide, on rigidifie ce liquide afin qu'il ne coule plus lorsqu'on retourne le substrat ou afin de pouvoir déposer une couche métallique par-dessus.
   - une phase de stabilisation finale permettant de mettre le matériau dans son état définitif, compatible avec le fonctionnement et la pérennité du dispositif.

La **figure 5** décrit un mode de mise en oeuvre optionnel mais avantageux de l'invention dans lequel le substrat de croissance 10c du premier ensemble multicouche 100 est un substrat élaboré de type SOI, acronyme de l'anglais « silicon on insulator », c'est-à-dire « silicium sur isolant ». Terme qui recouvre toute une gamme de substrats multicouches produits par l'industrie de la microélectronique qui permettent de réaliser dans une couche mince superficielle d'un matériau semi-conducteur, sur une couche d'isolation électrique 410, des circuits électroniques performants. La couche superficielle 10d de semi-conducteur et la couche d'isolation 410 sont elles mêmes supportées par un substrat receveur 420 généralement en silicium qui donne à l'ensemble une rigidité mécanique suffisante pour être manipulable. C'est la couche superficielle 10d qui est dans ce cas la couche à partir de laquelle on fait croître les fils 10 comme décrit précédemment.

L'avantage d'utiliser un substrat SOI est qu'il est connu de pouvoir « démonter » ce type de substrat SOI après transfert sur un substrat de report.

Différentes techniques connues de l'homme du métier peuvent être employées qui combinent attaques mécaniques, chimiques ou mécano chimiques (CMP) qui vont permettrent de ne laisser en place que la couche de croissance 10c que l'on pourra éventuellement garder ou faire disparaître en fonction de la spécificité du dispositif à fabriquer. Par exemple, la couche 10c pourra être initialement suffisamment conductrice, ou rendue conductrice ultérieurement, pour jouer le rôle de la seconde couche 50, décrite notamment dans la figure 2d, et destinée à l'interconnexion électrique des parties inférieures des fils formant les LEDs.

On peut ainsi prévoir d'effectuer une étape de décrochage de la couche isolante 410 et du substrat de receveur 420, cette étape de décrochage laissant la couche mince en place sur les fils.

Selon un mode de réalisation alternatif, on décroche la couche mince ainsi que la couche isolante 420 et le substrat de report 410.

Ainsi, l'utilisation d'un substrat élaboré de type SOI et des techniques de démontage du substrat mentionnées ci-dessus permettent de remplacer les étapes de décrochage et de démoulage partiel du substrat de croissance décrites dans les figures 3c et 3d et de ne pas avoir à employer les moyens de contraintes mécaniques correspondants.

Selon encore un autre mode de réalisation, l'ensemble du premier ensemble mulitcouche est laissé en place. La couche mince ainsi que la couche isolante 420 et le substrat de report 410 demeurent ainsi fixés aux fils. Le substrat de report 20 est quant à lui décroché de manière à laisser en place la couche de diélectrique 30 à l'intérieur de laquelle les fils sont insérés. Le deuxième ensemble multicouche comprenant plusieurs couches formant des électrodes 40, 50, ces couches sont également maintenues en place et au contact des fils après décrochage du substrat de report 20.

Selon encore un autre mode de réalisation, les couches 20, 410, 420 peuvent être amincies sans être supprimées en totalité.

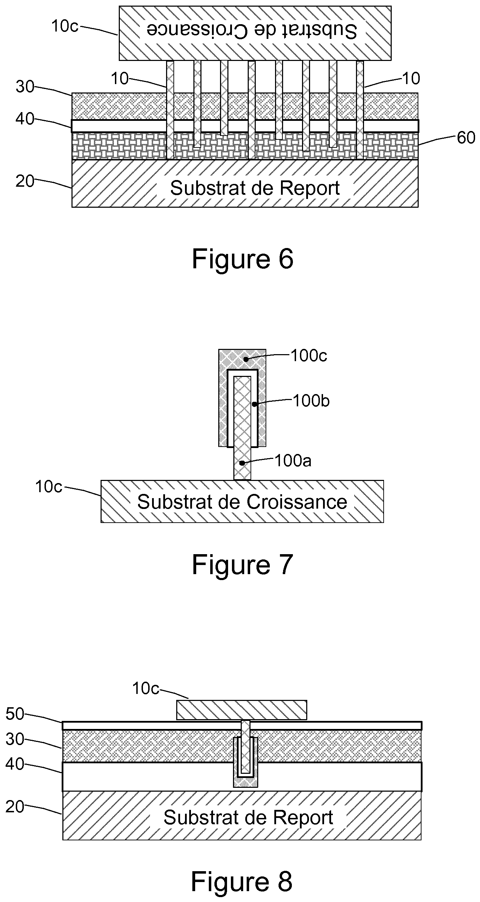

La **figure 6** illustre un exemple particulier, illustratif du contexte de la présente invention mais ne la définissant pas à lui seul, dans lequel on forme entre la première électrode 40 et le substrat de report 20 une couche additionnelle. Cette couche additionnelle, désignée couche de compensation 60, assure une compensation de la variabilité de la longueur des fils. Son épaisseur est de préférence supérieure au maximum de la différence de hauteur des longueurs des fils 10. Dans ces conditions on fait pénétrer les fils jusqu'à ce que les plus courts viennent, au minimum, en contact avec la première électrode 40, tous les autres la traversant et s'enfonçant plus ou moins dans la couche de compensation 60. Le contact électrique entre les fils et la première électrode 40 s'effectue donc correctement. La couche de compensation 60 est ainsi conformée pour absorber la différence de hauteur des fils. Ce contact se fait donc essentiellement au niveau de la périphérie des fils et non pas au niveau de leur extrémité. La couche de compensation 60 est par exemple réalisée en résine. De manière particulièrement avantageuse, cet exemple permet ainsi de proposer un procédé simple à mettre en oeuvre et fiable, quelle que soit la variabilité de la longueur des fils.

La **figure 7** illustre un deuxième mode de réalisation des fils dans lequel la deuxième partie 100b des fils recouvre une partie au moins des flancs de la première partie 100a. La troisième partie 100c recouvre à son tour une partie au moins des flancs de la deuxième 100b partie pour former une structure de fil qualifiée de « cœur-coquille » alors que la structure décrite précédemment est dite « axiale ».

Dans ce mode de réalisation, une extrémité de la première partie 100a est englobée par la deuxième partie 100b et par la troisième partie 100c. L'imbrication d'un premier ensemble selon cette structure dans le deuxième ensemble est illustrée en **figure 8****.**

De manière générale, une LED est composée d'une partie dopée n, d'une partie dopée p et éventuellement d'une zone dite active située entre la partie dopée n et la partie dopée p (diode PN ou diode PIN). C'est dans cette zone active qu'ont lieu les recombinaisons paire électron/trou. Une telle zone active peut être constituée de puits quantiques ou double hétérojonction ou d'une zone non intentionnellement dopée. La couche active est une couche dont l'énergie de bande interdite, habituellement désignée par le vocable anglais énergie de gap, est plus faible que celle des couches adjacentes à savoir P et N. Si c'est une diode PIN, alors il y a une double hétérojonction, si c'est des puits quantiques alors le matériau formant le puits est le même que celui utilisé pour la couche intrinsèque mais en général, il est entouré par des couches de barrière, habituellement désignées par le vocable anglais cladding layers, dont l'énergie de bande interdite est supérieure à celui de la couche intrinsèque et inférieur à celui des couches N et P.

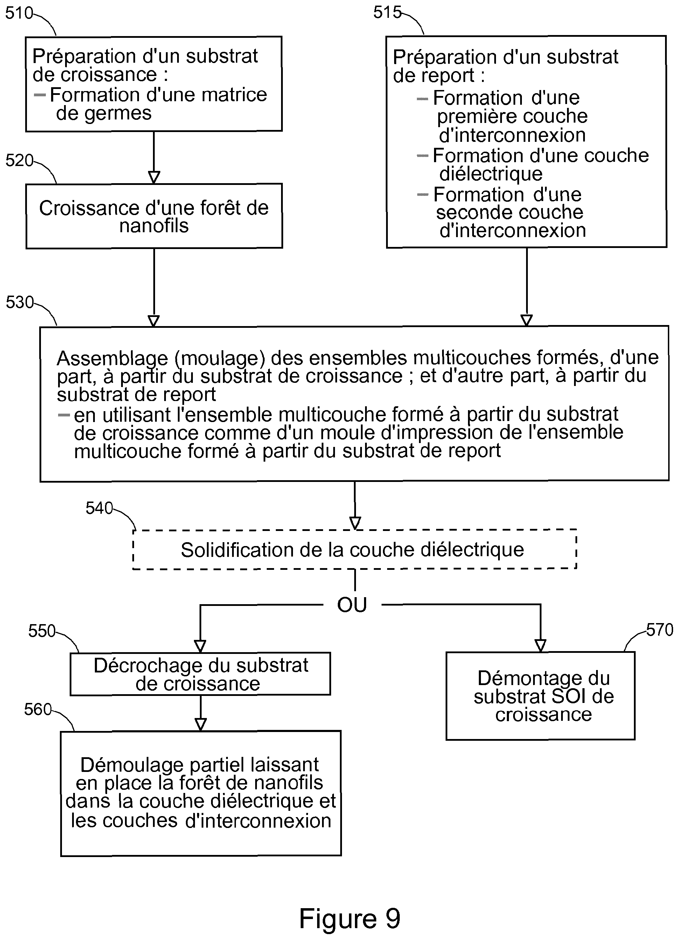

La **figure 9** résume les étapes du procédé de l'invention qui permet l'isolation de la forêt de fils. Le procédé de l'invention prévoit la préparation de deux ensembles multicouche distincts. D'une part celui contenant la forêt de fils qui, par exemple, va permettre d'obtenir autant de LEDs que de fils, à partir d'un substrat de croissance sur lequel on aura initialement formé 510 une matrice de germes de croissance. De taille nanométrique, les germes sont obtenus préférentiellement à partir de l'auto organisation, sous forme d'une matrice de plots, d'un matériau qui va permettre la croissance des fils faits généralement, comme on l'a vu, de matériaux semi-conducteurs. Optionnellement, les germes de croissance peuvent aussi être définis par des opérations classiques de photolithographie. La croissance 520 des fils et leur dopage intervient à l'étape suivante.

Un second ensemble multicouche est d'autre part préparé 515 à partir d'un substrat de report 20 sur lequel on va déposer au moins une couche d'un matériau diélectrique 30 destiné à assurer l'isolation électrique de la forêt de fils, avec une première 40 et une seconde 50 couche d'interconnexion des fils incluse de part et d'autre de la couche diélectrique 30.

Optionnellement, l'étape de formation 515 de la couche diélectrique 30 sur le substrat de report 20 est réalisée simultanément à l'étape de croissance 510 des fils.

À l'étape suivante 530, dite de pénétration ou de moulage, les deux ensembles multicouches sont assemblés en utilisant l'ensemble multicouche formé à partir du substrat de croissance et contenant les fils à isoler comme d'un moule d'impression de l'ensemble multicouche formé à partir du substrat de report. À ce stade, comme on l'a vu, on applique sur le moule une pression suffisante pour que la forêt de fils pénètre complètement la couche diélectrique, en ayant préalablement traversé la seconde couche d'interconnexion, jusqu'à venir en contact avec la première couche d'interconnexion, et/ou la pénétrer au moins partiellement.

À l'issue de cette étape une étape optionnelle de solidification de la couche diélectrique 540 intervient si l'état du matériau diélectrique utilisé le nécessite. En particulier, cette opération est nécessaire si le diélectrique est une résine liquide ou visqueuse que l'on va solidifier pour la rendre solidaire des fils.

L'étape suivante 550, est dite de décrochage. Elle consiste à fragiliser, par exemple à l'aide de différents moyens mécaniques décrits dans la figure 3c, les pieds des fils en vue du démoulage qui intervient à l'étape suivante 560 et qui consiste à enlever le substrat de croissance pour ne laisser en place que les fils maintenant prisonniers de la couche diélectrique et des couches d'interconnexion.

Comme décrit dans la figure 5 les étapes 550 et 560 sont optionnellement remplacées par une étape 570 de démontage d'un substrat de type SOI si ce type de substrat élaboré a été initialement utilisé comme substrat de croissance à l'étape 510.

Enfin, quoique décrit à travers l'exemple particulier de la fabrication de diodes électroluminescentes filaires, le procédé divulgué ci-dessus pourra s'appliquer en général à l'isolation de fils, qui, avec leur substrat de croissance, pourront être utilisés comme moule d'impression d'une couche diélectrique qui aura été préparée sur un substrat distinct de report dans le cadre de la fabrication d'un dispositif micro électronique et/ou optique quelconque. La présente invention est définie par les revendications qui suivent.

## Revendications

1. Procédé de réalisation d'un dispositif microélectronique comprenant une pluralité de diodes électroluminescentes (10) comprenant chacune un fil de taille nanométrique ou micrométrique, le procédé comprenant:
- une étape de croissance (520) des fils à partir d'un substrat de croissance (10c), lesdits fils s'étendant depuis le substrat de croissance (10c) et selon une direction sensiblement perpendiculaire au substrat de croissance (10c),
- une étape de formation d'au moins une première électrode (40) recouvrant un substrat de report (20) distinct du substrat de croissance (10c),
- une étape de formation d'au moins une couche diélectrique (30) sur la première électrode (40),
- une étape de formation d'au moins une deuxième électrode (50) sur la couche diélectrique (30), de sorte que la couche diélectrique (30) est disposée entre la première électrode (40) et la deuxième électrode (50), et
- une étape de pénétration (530) des fils dans la couche diélectrique (30) faisant suite à l'étape de formation de l'au moins une deuxième électrode (50).

2. Procédé selon la revendication précédente, dans lequel l'étape de pénétration (530) est effectuée de sorte que les fils traversent totalement la couche diélectrique (30).

3. Procédé selon l'une quelconque des revendications précédentes, dans lequel l'étape de pénétration comprend l'application sur l'un parmi le substrat de croissance (10c) ou le substrat de report (20) d'une force de pressage appliquée selon une direction sensiblement parallèle à la direction longitudinale des fils.

4. Procédé selon la revendication précédente, dans lequel la force de pressage présente une amplitude telle que la contrainte exercée par certains au moins des fils sur la couche diélectrique (30) est supérieure à la limite plastique de la couche diélectrique (30).

5. Procédé selon l'une quelconque des revendications précédentes, dans lequel la première électrode (40) recouvre totalement la couche diélectrique (30).

6. Procédé selon l'une quelconque des revendications 1 à 4, dans lequel la première électrode (40) recouvre partiellement la couche diélectrique (30).

7. Procédé selon l'une quelconque des revendications précédentes, comprenant, préalablement à l'étape de formation de la au moins une première électrode (40), une étape de formation d'une couche de compensation (60) recouvrant au moins partiellement le substrat de report (20) et dont l'épaisseur est au moins égale à la différence maximale de hauteur entre deux fils.

8. Procédé selon l'une quelconque des revendications précédentes, dans lequel la somme des épaisseurs de la première électrode (40), de la couche diélectrique (30) et de la deuxième électrode (50) est inférieure ou égale à la hauteur de certains au moins des fils.

9. Procédé selon l'une quelconque des revendications précédentes, dans lequel la couche diélectrique (30) présente une épaisseur comprise entre 10 nanomètres et 500 micromètres.

10. Procédé selon l'une quelconque des revendications précédentes, comprenant, après l'étape de pénétration, une étape de décrochage (550) du substrat de croissance (10c) au cours de laquelle on retire le substrat de croissance (10c) tout en laissant les fils partiellement au moins à l'intérieur de la couche diélectrique (30).

11. Procédé selon l'une quelconque des revendications 1 à 9, dans lequel le substrat de croissance (10c) forme un empilement comprenant une couche mince (10d) d'un matériau semiconducteur surmontant une couche isolante (410) qui surmonte elle-même un substrat receveur (420) ; le procédé comprenant, après l'étape de pénétration, une étape de décrochage du substrat de report (20) au cours de laquelle on retire le substrat de report (20) tout en laissant en place la couche diélectrique (30) à l'intérieure de laquelle les fils sont contenus au moins partiellement.

12. Procédé selon l'une quelconque des deux revendications précédentes, dans lequel l'étape de décrochage (550) comprend une application sur l'un parmi le substrat de croissance (10c) ou le substrat de report (20) d'une force principale (240, 250) appliquée selon une direction sensiblement orthogonale à la direction longitudinale des fils et comprend : soit l'application sur l'autre parmi le substrat de croissance (10c) ou le substrat de report (20) d'une autre force (250, 240) appliquée selon une même direction que celle de la force principale et selon un sens inverse à celle de la force principale, soit le maintien de l'autre parmi le substrat de croissance (10c) ou le substrat de report (20).

13. Procédé selon l'une quelconque des revendications 10 ou 11, dans lequel l'étape de décrochage comprend une application, sur l'un parmi le substrat de croissance (10c) ou le substrat de report (20) d'un couple principal de torsion (280) autour d'un axe sensiblement parallèle à une direction longitudinale des fils et comprend : soit l'application sur l'autre parmi le substrat de croissance (10c) ou le substrat de report (20) d'un autre couple appliqué autour d'un même axe que celui du couple principal et selon un sens inverse à celui du couple principal, soit le maintien de l'autre parmi le substrat de croissance (10c) ou le substrat de report (20).

14. Procédé selon l'une quelconque des quatre revendications précédentes, dans lequel l'étape de décrochage comprend une étape d'application d'ondes ultrasonores (230) ou de vibrations.

15. Procédé selon l'une quelconque des revendications précédentes, dans lequel l'étape de formation (515) de la couche diélectrique (30) sur le substrat de report (20) est réalisée simultanément à l'étape de croissance (520) des fils.

16. Procédé selon l'une quelconque des revendications précédentes, dans lequel les fils présentent une longueur inférieure à 500 micromètres.

17. Jeu d'ensembles multicouches comprenant au moins un premier ensemble multicouche (100) comprenant un substrat de croissance (10c) et une pluralité de diodes électroluminescentes (10) comprenant chacune un fil de taille nanométrique ou micrométrique s'étendant depuis le substrat de croissance (10c) et selon une direction sensiblement perpendiculaire au substrat de croissance (10c), et comprenant également au moins un deuxième ensemble multicouche (200) distinct du premier ensemble multicouche (100), le deuxième ensemble multicouche comprenant un substrat de report (20) surmonté successivement d'une première électrode (40), d'une couche diélectrique (30) et d'une deuxième électrode (50), de sorte que la couche diélectrique (30) est disposée entre les première et deuxième électrodes (40, 50), les premier et deuxième ensembles multicouches étant configurés de sorte que leur imbrication permet aux fils de pénétrer dans la couche diélectrique (30), en ayant ladite première électrode (40) en contact avec au moins certains des fils et, en ayant ladite deuxième électrode (50) en contact avec au moins certains des fils.

18. Jeu selon la revendication précédente, comprenant une couche de compensation (60) disposée entre la première électrode (40) et le substrat de report (20).

19. Jeu selon la revendication précédente, dans lequel l'épaisseur de la couche de compensation (60) est au moins égale à la différence maximale de hauteur entre deux fils.

20. Jeu selon l'une quelconque des trois revendications précédentes, dans lequel le substrat de croissance (10c) est un ensemble multicouche (400) de type silicium-sur-isolant (SOI).

21. Jeu selon l'une quelconque des quatre revendications précédentes, dans lequel chaque fil du premier ensemble multicouche présente : une première partie (100a) en matériau semi-conducteur présentant un premier dopage, ladite première partie étant en contact avec le substrat de croissance (10c); une deuxième partie (100b) en matériau semi-conducteur intrinsèque, ladite deuxième partie (100b) étant disposée sur ou englobant en partie ladite première partie (100a); une troisième partie (100c) en matériau semi-conducteur présentant un deuxième dopage, ladite troisième partie (100c) étant disposée sur ou englobant en partie ladite deuxième partie (100b).

22. Jeu selon la revendication précédente dans lequel la longueur de certains au moins des fils est supérieure ou égale à l'épaisseur de la couche diélectrique (30) et la couche diélectrique (30) présente une épaisseur supérieure ou égale à l'épaisseur de ladite troisième partie (100c) et inférieure ou égale à la hauteur des fils.

## Patentansprüche

1. Verfahren zur Herstellung einer mikroelektronischen Vorrichtung mit einer Vielzahl von Leuchtdioden (10), umfassend jeweils einen Draht einer Größe im Nanometer- oder Mikrometerbereich, wobei das Verfahren Folgendes umfasst:
- einen Schritt des Wachsens (520) der Drähte ausgehend von einem Wachstumssubstrat (10c), wobei sich die Drähte vom Wachstumssubstrat (10c) und gemäß einer Richtung erstrecken, die im Wesentlichen senkrecht zum Wachstumssubstrat (10c) ist,
- einen Schritt des Bildens mindestens einer ersten Elektrode (40), die ein Transfersubstrat (20) bedeckt, das verschieden vom Wachstumssubstrat (10c) ist,
- einen Schritt des Bildens mindestens einer dielektrischen Schicht (30) auf der ersten Elektrode (40),
- einen Schritt des Bildens mindestens einer zweiten Elektrode (50) auf der dielektrischen Schicht (30), so dass die dielektrische Schicht (30) zwischen der ersten Elektrode (40) und der zweiten Elektrode (50) angeordnet ist, und
- einen Schritt des Eindringens (530) der Drähte in die dielektrische Schicht (30) nach dem Schritt des Bildens der mindestens einen zweiten Elektrode (50).

2. Verfahren nach dem vorhergehenden Anspruch, wobei der Schritt des Eindringens (530) derart durchgeführt wird, dass die Drähte die dielektrische Schicht (30) vollständig queren.

3. Verfahren nach einem der vorhergehenden Ansprüche, **dadurch gekennzeichnet, dass** der Schritt des Eindringens die Anwendung auf eines aus dem Wachstumssubstrat (10c) oder dem Transfersubstrat (20) einer Druckkraft umfasst, die gemäß einer Richtung angewendet wird, die im Wesentlichen parallel zur Längsrichtung der Drähte ist.

4. Verfahren nach dem vorhergehenden Anspruch, wobei die Druckkraft eine derartige Amplitude aufweist, dass die Spannung, ausgeübt von mindestens einigen der Drähte auf die dielektrische Schicht (30), höher als die Plastizitätsgrenze der dielektrischen Schicht (30) ist.

5. Verfahren nach einem der vorhergehenden Ansprüche, **dadurch gekennzeichnet, dass** die erste Elektrode (40) die dielektrische Schicht vollständig bedeckt (30) .

6. Verfahren nach einem der Ansprüche 1 bis 4, wobei die erste Elektrode (40) die dielektrische Schicht teilweise bedeckt (30).

7. Verfahren nach einem der vorhergehenden Ansprüche, umfassend, vor dem Schritt des Bildens der mindestens einen ersten Elektrode (40), einen Schritt des Bildens einer Kompensationsschicht (60), die mindestens teilweise das Transfersubstrat (20) bedeckt, und deren Dicke mindestens gleich der maximalen Höhendifferenz zwischen zwei Drähten ist.

8. Verfahren nach einem der vorhergehenden Ansprüche, **dadurch gekennzeichnet, dass** die Summe der Dicken der ersten Elektrode (40), der dielektrischen Schicht (30) und der zweiten Elektrode (50) kleiner als oder gleich wie die Höhe mindestens Bestimmter der Drähte ist.

9. Verfahren nach einem der vorhergehenden Ansprüche, **dadurch gekennzeichnet, dass** der dielektrischen Schicht (30) eine Dicke aufweist, die zwischen 10 Nanometern und 500 Mikrometern liegt.

10. Verfahren nach einem der vorhergehenden Ansprüche, umfassend, nach dem Schritt des Eindringens, einen Schritt des Lösens (550) des Wachstumssubstrats (10c), im Laufe dessen das Wachstumssubstrat (10c) entfernt und gleichzeitig die Drähte mindestens teilweise im Inneren der dielektrischen Schicht (30) belassen werden.

11. Verfahren nach einem der Ansprüche 1 bis 9, wobei das Wachstumssubstrat (10c) einen Stapel bildet, umfassend eine dünne Schicht (10d) aus einem halbleitenden Material, das eine Isolierschicht (410) überlagert, die selbst ein Aufnahmesubstrat (420) überlagert; wobei das Verfahren, nach dem Schritt des Eindringens, einen Schritt des Lösens des Transportsubstrats (20) umfasst, im Laufe dessen das Transportsubstrat (20) entfernt und gleichzeitig die dielektrische Schicht in ihrer Position (30) belassen wird, in deren Innerem die Drähte mindestens teilweise enthalten sind.

12. Verfahren nach einem der zwei vorhergehenden Ansprüche, wobei der Schritt des Lösens (550) eine Anwendung auf einem des Wachstumssubstrats (10c) oder des Transportsubstrats (20) einer Hauptkraft (240, 250) umfasst, die gemäß einer im Wesentlichen orthogonalen Richtung zur Längsrichtung der Drähte angewendet wird und Folgendes umfasst: entweder die Anwendung auf dem anderen des Wachstumssubstrats (10c) oder des Transportsubstrats (20) einer anderen Kraft (250, 240), angewendet gemäß einer gleichen Richtung wie derjenigen der Hauptkraft und gemäß einer umgekehrten Richtung zu derjenigen der Hauptkraft, oder die Beibehaltung des anderen des Wachstumssubstrats (10c) oder des Transportsubstrats (20).

13. Verfahren nach einem der Ansprüche 10 oder 11, wobei der Schritt des Lösens eine Anwendung, auf einem des Wachstumssubstrats (10c) oder des Transfersubstrats (20), eines Hauptdrehmoments (280) um eine Achse umfasst, die im Wesentlichen parallel zu einer Längsrichtung der Drähte ist und Folgendes umfasst: entweder die Anwendung auf dem anderen des Wachstumssubstrats (10c) oder des Transportsubstrats (20) eines anderen Moments, das um eine gleiche Achse wie diejenige des Hauptmoments angewendet ist, und gemäß einer umgekehrten Richtung zu derjenigen des Hauptmoments, oder die Beibehaltung des anderen des Wachstumssubstrats (10c) oder des Transportsubstrats (20).

14. Verfahren nach einem der vier vorhergehenden Ansprüche, wobei der Schritt des Ablösens einen Schritt des Anwendens von Ultraschallwellen (130) oder Vibrationen umfasst.

15. Verfahren nach einem der vorhergehenden Ansprüche, wobei der Schritt des Bildens (515) der dielektrischen Schicht (30) auf dem Transportsubstrat (20) gleichzeitig mit dem Schritt des Wachsens (520) der Drähte durchgeführt wird.

16. Verfahren nach einem der vorhergehenden Ansprüche, **dadurch gekennzeichnet, dass** die Drähte eine Länge von weniger als 500 Mikrometer aufweisen.

17. Anzahl von Mehrfachschichten, umfassend mindestens eine erste Mehrfachschicht (100), umfassend ein Wachstumssubstrat (10c) und eine Vielzahl von Leuchtdioden (10), umfassend jeweils einen Draht einer Größe im Nanometer- oder Mikrometerbereich, der sich vom Wachstumssubstrat (10c) und gemäß einer Richtung erstreckt, die im Wesentlichen senkrecht zum Wachstumssubstrat (10c) ist, und umfassend ebenfalls mindestens eine zweite Mehrfachschicht (200), die verschieden von der ersten Mehrfachschicht (100) ist, wobei die zweite Mehrfachschicht ein Transportsubstrat (20) umfasst, überlagert aufeinanderfolgend von einer ersten Elektrode (40), einer dielektrischen Schicht (30) und einer zweiten Elektrode (50), so dass die dielektrische Schicht (30) zwischen der ersten und zweiten Elektrode (40, 50) angeordnet ist, wobei die erste und zweite Mehrfachschicht derart konfiguriert ist, dass ihre Verflechtung den Drähten ermöglicht, in die dielektrische Schicht (30) einzudringen, indem die erste Elektrode (40) in Kontakt mit mindestens bestimmten der Drähte ist, und indem die zweite Elektrode (50) in Kontakt mit mindestens bestimmten der Drähte ist..

18. Anzahl nach dem vorhergehenden Anspruch, umfassend eine Kompensationsschicht (60), die zwischen der ersten Elektrode (40) und dem Transportsubstrat (20) angeordnet ist.

19. Anzahl nach dem vorhergehenden Anspruch, wobei die Dicke der Kompensationsschicht (60) mindestens gleich der maximalen Höhendifferenz zwischen zwei Drähten ist.

20. Anzahl nach einem der drei vorhergehenden Ansprüche, wobei das Wachstumssubstrat (10c) eine Mehrfachschicht (400) vom Typ Silizium auf Isolator (SOI) ist.

21. Anzahl nach einem der vier vorhergehenden Ansprüche, wobei jeder Draht der ersten Mehrfachschicht einen ersten Teil (100a) aus halbleitendem Material aufweist, der eine erste Dotierung aufweist, wobei der erste Teil in Kontakt mit dem Wachstumssubstrat (10c) ist, einen zweiten Teil (100b) aus intrinsischem halbleitendem Material, wobei der zweite Teil (100b) auf dem ersten Teil (100a) angeordnet ist oder teilweise diesen einschließt; einen dritten Teil (100c) aus halbleitendem Material, der eine zweite Dotierung aufweist, wobei der dritte Teil (100C) auf dem zweiten Teil (100b) angeordnet ist oder teilweise diesen einschließt.

22. Anzahl nach dem vorhergehenden Anspruch, wobei die Länge mindestens bestimmter der Drähte größer als oder gleich wie die Dicke der dielektrischen Schicht (30) ist und die dielektrische Schicht (30) eine Dicke aufweist, die größer als oder gleich wie die Dicke des dritten Teils (100c) und kleiner als oder gleich wie die Höhe der Drähte ist.

## Claims

1. Method for producing a microelectronic device comprising a plurality of light-emitting diodes (10) each comprising a wire of nanometric or micrometric size, the method comprising:
- a step (520) of growth of the wires from a growth substrate (10c), said wires extending from the growth substrate (10c) and in a direction substantially perpendicular to the growth substrate (10c)
- a step of forming at least one first electrode (40) covering a transfer substrate (20) distinct from the growth substrate (10c),
- a step of forming at least one dielectric layer (30) on the first electrode (40),
- a step of forming at least one second electrode (50) on the dielectric layer (30), so that the dielectric layer (30) is disposed between the first electrode (40) and the second electrode (50), and
- a step (530) of penetration of the wires in the dielectric layer (30) following the step of forming the at least one second electrode (50).

2. Method according to the preceding claim, wherein the penetration step (530) is performed so that the wires pass completely through the dielectric layer (30).

3. Method according to either of the preceding claims, wherein the penetration step comprises the application, to either the growth substrate (10c) or the transfer substrate (20), of a pressing force applied in a direction substantially parallel to the longitudinal direction of the wires.

4. Method according to the preceding claim, wherein the pressing force has an amplitude such that the force exerted by at least some of the wires on the dielectric layer (30) is greater than the plastic limit of the dielectric layer (30).

5. Method according to any of the preceding claims, wherein the first electrode (40) completely covers the dielectric layer (30).

6. Method according to any of claims 1 to 4, wherein the first electrode (40) partially covers the dielectric layer (30).

7. Method according to any of the preceding claims, comprising, prior to the step of forming the at least one first electrode (40), a step of forming a compensation layer (60) at least partially covering the transfer substrate (20) and the thickness of which is at least equal to the maximum difference in height between two wires.

8. Method according to any of the preceding claims, wherein the sum of the thicknesses of the first electrode (40), of the dielectric layer (30) and of the second electrode (50) is less than or equal to the height of at least some of the wires.

9. Method according to any of the preceding claims, wherein the dielectric layer (30) has a thickness of between 10 nanometres and 500 micrometres.

10. Method according to any of the preceding claims, comprising, after the penetration step, a step (550) of detaching the growth substrate (10c) during which the growth substrate (10c) is removed while leaving the wires at least partially inside the dielectric layer (30).

11. Method according to any of claims 1 to 9, wherein the growth substrate (10c) forms a stack comprising a thin layer (10d) of a semiconductor material surmounting an insulating layer (410) that itself surmounts a receiver substrate (420); the method comprising, after the penetration step, a step of detaching the transfer substrate (20) during which the transfer substrate (20) is removed while leaving in place the dielectric layer (30) inside which the wires are at least partially contained.

12. Method according to any of the two preceding claims, wherein the detachment step (550) comprises an application, to either the growth substrate (10c) or the transfer substrate (20), of a principal force (240, 250) applied in a direction substantially orthogonal to the longitudinal direction of the wires and comprises: either the application to the other one from the growth substrate (10c) or the transfer substrate (20) of another force (250, 240) applied along same axis as the direction of the principal force and in a direction opposite to that of the principal force, or the maintenance of the other one from the growth substrate (10c) or the transfer substrate (20).

13. Method according to any one of claim 10 or 11, wherein the detachment step comprises an application, on either the growth substrate (10c) or the transfer substrate (20), of a principal torque (280) about an axis substantially parallel to a longitudinal direction of the wires and comprises: either the application to the other one from the growth substrate (10c) or the transfer substrate (20) of another torque applied about the same axis as that of the principal torque and in an opposite direction to that of the principal torque, or the maintenance of the other one from the growth substrate (10c) or the transfer substrate (20).

14. Method according to any of the four preceding claims, wherein the detachment step comprises a step of applying ultrasound waves (230) or vibrations.

15. Method according to any of the preceding claims, wherein the step (515) of forming the dielectric layer (30) on the transfer substrate (20) is carried out simultaneously with the step (520) of growth of the wires.

16. Method according to any of the preceding claims, wherein the wires have a length of less than 500 micrometres.

17. Set of multilayer assemblies comprising at least one first multilayer assembly (100) comprising a growth substrate (10c) and a plurality of light-emitting diodes (10) each comprising a wire of nanometric or micrometric size extending from the growth substrate (10c) in a direction substantially perpendicular to the growth substrate (10c), and also comprising at least one second multilayer assembly (200) distinct from the first multilayer assembly (100), the second multilayer assembly comprising a transfer substrate (20) surmounted successively by a first electrode (40), a dielectric layer (30) and a second electrode (50), so that the dielectric layer (30) is disposed between the first and second electrodes (40, 50), the first and second multilayer assemblies being configured so that the interlacing thereof enables the wires to penetrate the dielectric layer (30), while having said first electrode (40) in contact with at least some of the wires and having said second electrode (50) in contact with at least some of the wires.

18. Set according to the preceding claim, comprising a compensation layer (60) disposed between the first electrode (40) and the transfer substrate (20).

19. Set according to the preceding claim, wherein the thickness of the compensation layer (60) is at least equal to the maximum difference in height between two wires.

20. Set according to any of the three preceding claims, wherein the growth substrate (10c) is a multilayer assembly (400) of the silicon-on-insulator (SOI) type.

21. Set according to any of the four preceding claims, wherein each wire in the first multilayer assembly has: a first part (100a) made from semiconductor material having a first doping, said first part being in contact with the growth substrate (10c); a second part (100b) made from intrinsic semiconductor material, said second part (100b) being disposed on or partly encompassing said first part (100a); a third part (100c) made from semiconductor material having a second doping, said third part (100c) being disposed on or partly encompassing said second part (100b).

22. Set according to the preceding claim, wherein the length of at least some of the wires is greater than or equal to the thickness of the dielectric layer (30) and the dielectric layer (30) has a thickness greater than or equal to the thickness of the third part (100c) and less than or equal to the height of the wires.
